# EUROPEAN PATENT SPECIFICATION

(11) **EP 3 550 715 B1**
(45) Date of publication and mention of the grant of the patent: **24.02.2021**
(21) Application number: 17876247.2
(22) Date of filing: 28.09.2017
(51) Int. Cl.: H02N 2/18

(54) **POWER GENERATION DEVICE**
STROMERZEUGUNGSVORRICHTUNG
DISPOSITIF DE PRODUCTION D'ÉNERGIE

(30) Priority: 02.12.2016 JP 2016234665
(43) Date of publication of application: 09.10.2019
(73) Proprietor: Panasonic Intellectual Property Management Co., Ltd., Osaka-shi, Osaka 540-6207 (JP)
(72) Inventor: FUDO, Kohei, Osaka-shi, Osaka 540-6207 (JP); SAWADA, Masaki, Osaka-shi, Osaka 540-6207 (JP); NAKAMURA, Takaya, Osaka-shi, Osaka 540-6207 (JP)
(74) Representative: Vigand, Philippe
(86) International application number: PCT/JP2017/035090
(87) International publication number: WO 2018/100859

(56) References cited:
- EP-A1- 3 447 902
- WO-A1-2014/076895
- GB-A- 1 028 059
- JP-A- 2013 118 766
- US-A1- 2014 097 709

## Description

### TECHNICAL FIELD

The present disclosure relates to a power generation device used for an independent electronic apparatus or the like.

### BACKGROUND ART

Hereinafter, a conventional power generation device will be described. The conventional power generation device includes a start-up unit, an attraction body, and a power generation unit having a cantilever shape. The power generation unit generates electricity by being vibrated. The attraction body is coupled with the start-up unit, and works with the start-up unit. Then, the start-up unit is attracted to the power generation unit by magnetic force in a state where it is positioned at a start point. The start-up unit moves in a direction perpendicular to the power generation unit in an initial state (hereinafter, simply referred to as perpendicular direction). This also makes the attraction body move in the same direction as the start-up unit. That is, the power generation unit deflects with movement of the attraction body. Then, when the start-up unit moves to an end point, attraction between the attraction body and the power generation unit is released. Then, by being separated from the attraction body, the power generation unit starts to vibrate. As to information on prior art literature relevant to the disclosure of this application, for example, PTL 1 is known.

### Citation List

### Patent Literature

PTL 1: Unexamined Japanese Patent Publication No. 2006-158113

The document US 2014/0097709 A1 describes a power generation switch, wherein a pivoting lever arrangement carrying an attraction magnet serves to release a cantilevered power generation unit into free vibration.

The document GB 1028059 describes a signal generating arrangement of similar construction.

### SUMMARY OF THE INVENTION

A power generation device according to the present invention includes a start-up unit that includes an attraction body and moves from a start point toward an end point, and a power generation unit that generates electricity by being vibrated, the power generation unit having a cantilever shape. Then, the attraction body attracts the power generation unit when the start-up unit moves from the start point toward the end point, the power generation unit deflects and inclines due to movement of the attraction body of the start-up unit and the power generation unit toward the end point while the power generation unit is attracted to the attraction body, the power generation unit starts to vibrate by separation of the attraction body from the power generation unit, and the attraction body inclines in a direction along an inclination of the power generation unit. The start-up unit furthermore features a rotation supporting point as defined in claim 1.

### BRIEF DESCRIPTION OF DRAWINGS

FIG. 1A is a schematic view of a power generation device in an exemplary realisation similar to the above-mentioned prior art.
FIG. 1B is a perspective view of the power generation device of FIG. 1A.
FIG. 2A is a perspective view of a start-up unit according to an embodiment of the present invention.
FIG. 2B is an enlarged cross-sectional view of a main part of a holder according to the exemplary embodiment of FIG. 2A.
FIG. 3 is an enlarged cross-sectional view of the main part of the holder according to another embodiment of the present invention.
FIG. 4A to FIG. 4D illustrate the general operation of the disclosed power generation devices.
FIG. 5A to FIG. 5C and FIG. 6A to FIG. 6C illustrate the operation of power generation devices according to the present invention.
FIG. 7 is a conceptual diagram of a power generation device according to a first modification of a power generation device according to the present invention.
FIG. 8 is a conceptual diagram of a power generation device according to a second modification of a power generation device outside the scope of the present invention.

### DESCRIPTION OF EMBODIMENT

Hereinafter, exemplary power generation devices will be described with reference to the accompanying drawings. It should be noted that components assigned the same reference numerals in the exemplary embodiment operate similarly, and therefore redundant descriptions may be omitted.

Terms indicating directions, such as "front", "rear", "width direction", "length direction", and the like only indicate relatively positional relationships, and the present disclosure is not limited thereto.

### (First exemplary embodiment)

### [Configuration of power generation device 11]

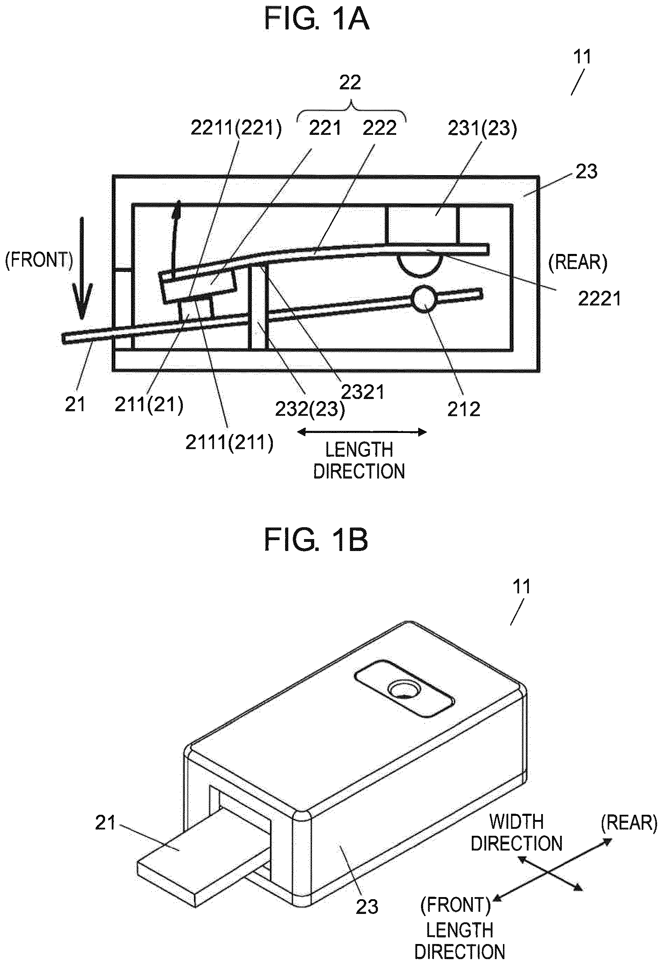

FIG. 1A is a schematic view of power generation device 11 similar to the devices of the above-mentioned prior art. FIG. 1B is a perspective view of power generation device 11. Hereinafter, power generation device 11 will be described with reference to FIG. 1A and FIG. 1B. Power generation device 11 includes a start-up unit 21 and power generation unit 22. Power generation unit 22 has a cantilever shape. Then, power generation unit 22 starts to vibrate by movement of start-up unit 21, and generates electricity. Start-up unit 21 includes attraction body 211. Then, when start-up unit 21 moves, attraction surface 2111 of attraction body 211 moves from a start point toward an end point.

When attraction body 211 moves from the start point toward the end point, attraction body 211 attracts power generation unit 22 by magnetic force. When attraction body 211 moves toward the end point while attracting power generation unit 22, power generation unit 22 deflects. Deflection of power generation unit 22 leads to inclination of power generation unit 22. Then, on the way of further movement of attraction body 211 toward the end point, attraction body 211 is separated from power generation unit 22. Separation of attraction body 211 makes power generation unit 22 start to vibrate. Attraction body 211 of start-up unit 21 is configured to incline in a direction along an inclination of power generation unit 22.

The above-mentioned configuration makes attraction body 211 of start-up unit 21 incline in the direction along the inclination of power generation unit 22 depending on movement of start-up unit 21. This makes it possible to suppress reduction of a contact area between attraction body 211 and power generation unit 22 when attraction body 211 moves.

That is, power generation device 11 of the present disclosure makes it possible to reduce variation of attraction force between power generation unit 22 and attraction body 211 in a state where power generation unit 22 and attraction body 211 are attracted. At the same time, power generation device 11 enables to suppress variation of a position when power generation unit 22 and attraction body 211 are separated. This enables power generation device 11 to stable amplitude width of power generation unit 22 to stable power generation amount by power generation unit 22.

### [Specific example of configuration of power generation device 11]

Next, a specific configuration of power generation device 11 will be described in detail with reference to FIGS. 1A to FIG. 3. Power generation device 11 may include case 23 as illustrated in FIG. 1A. Start-up unit 21 and power generation unit 22 are housed in case 23. However, a distal end of start-up unit 21 passes through case 23 and protrudes from case 23 toward outside.

Power generation unit 22 is composed by, for example, forming a piezoelectric element film on a surface of a metal plate or the like. The metal plate (beam 222) of power generation unit 22 is formed of an elastic member. Examples of the metal plate (beam 222) used for power generation unit 22 include stainless. Power generation unit 22 has a cantilever shape, and fixed to case 23 at root 2221 (fixed end). Note that, power generation unit 22 is disposed in case 23 such that a void exists between power generation unit 22 and case 23 having a size of not less than a vibration amplitude of power generation unit 22. Spacer 231 or the like is provided between root 2221 of power generation unit 22 and an upper surface of case 23. Spacer 231 is preferably integrally formed with case 23. Note that spacer 231 may be composed by an element different from case 23. Power generation unit 22 is fixed inside case 23 via spacer 231.

Attraction body 211 has attraction surface 2111 opposing power generation unit 22. Attraction surface 2111 is attracted to power generation unit 22 by magnetic force. When power generation unit 22 is made of a magnetic material, attraction body 211 is preferably a magnet. In power generation device 11 according to the exemplary embodiment, power generation unit 22 includes attraction body 221. Note that power generation unit 22 preferably includes attraction body 221. Attraction body 221 has attraction surface 2211 opposing start-up unit 21 of power generation unit 22. Then, attraction surface 2211 is disposed at a position opposed to attraction surface 2111. Attraction body 221 is formed of a magnetic material. This makes attraction surface 2111 of attraction body 211 be attracted to attraction surface 2211 of attraction body 221. This configuration makes power generation unit 22 in a range where attraction body 211 is attached be less likely to be bent. Accordingly, attraction surface 2111 is attracted to attraction surface 2211 without a gap.

Note that, in the above-mentioned exemplary embodiment, although attraction body 221 is formed of a magnetic material, this is not limited thereto. Both attraction body 211 and attraction body 221 may be a magnet. However, in this case, attraction body 221 and attraction body 211 need to be disposed such that their different magnetic poles are opposed.

As another configuration, attraction body 221 may be a magnet and attraction body 211 may be formed of a magnetic material.

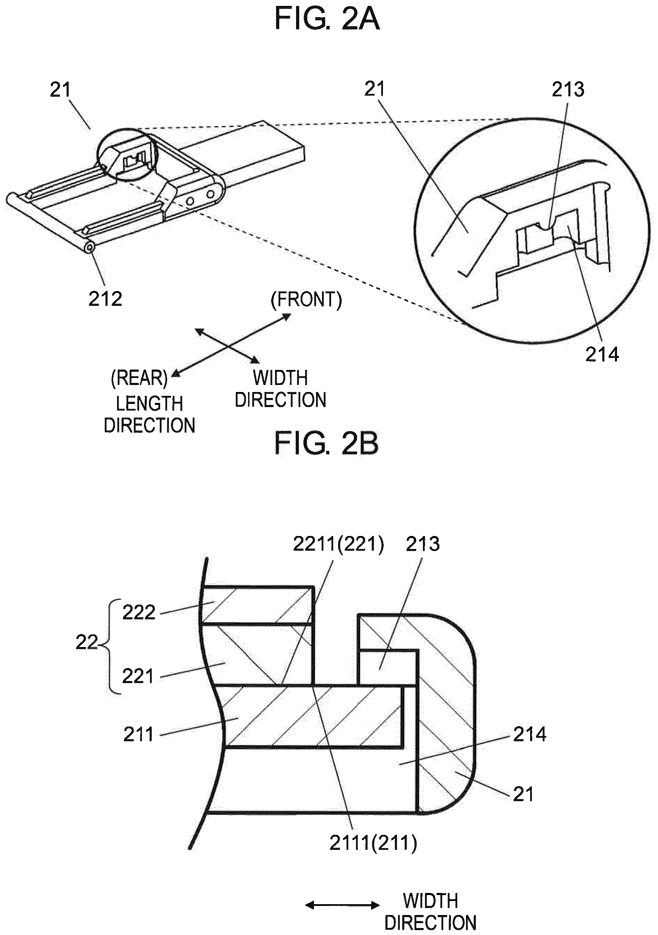

FIG. 2A is a perspective view of start-up unit 21 according to the present invention. FIG. 2A also illustrates a partial enlarged view.

Note that a direction indicated in FIG. 2A differs from a direction indicated in FIG. 1B. Although attraction body 211 of start-up unit 21 is disposed at holder 214, attraction body 211 is not illustrated in FIG. 2A for easy understanding of a holding structure.

FIG. 2B is a cross-sectional schematic view in a width direction of a main part of start-up unit 21 illustrated in FIG. 2A. In FIG. 2B, holder 214 holds attraction body 211. Also, attraction body 211 and attraction body 221 are attracted.

As illustrated in FIG. 2A, start-up unit 21 preferably has second rotation supporting point 212. This structure makes start-up unit 21 turn around second rotation supporting point 212 as a center. Accordingly, attraction body 211 turns around second rotation supporting point 212 as a center when start-up unit 21 is moved. Note that, although start-up unit 21 turns around second rotation supporting point 212 as a supporting point, the present disclosure is not limited to this configuration, and start-up unit 21 may be a cantilever in which one end of start-up unit 21 is a fixed end. In these cases, the fixed end (not shown) of start-up unit 21 or second rotation supporting point 212 (hereinafter, collectively referred to as a supporting point) is preferably disposed closer to a root of power generation unit 22 than attraction body 211. This configuration enables attraction body 211 turns around to incline in a direction along an inclination of power generation unit 22 when start-up unit 21 moves from the start point toward the end point (from upper direction toward lower direction in FIG. 1A).

Note that start-up unit 21 preferably has a rod shape extending in a straight line between attraction body 211 and second rotation supporting point 212. In contrast, a distant end from attraction body 211 of start-up unit 21 may has any shape as long as it is readily operated by an operator or an operating device as appropriate. Furthermore, start-up unit 21 may include a conversion mechanism such as a cam mechanism or a crank mechanism. These structures enable to reverse moving direction of start-up unit 21. That is, these structures enables to make the start point be in a lower direction of the drawing and the end point be in an upper direction of the drawing. These structures also enables to make attraction body 211 turn around and make the distal end of start-up unit 21 moves in a straight-line manner.

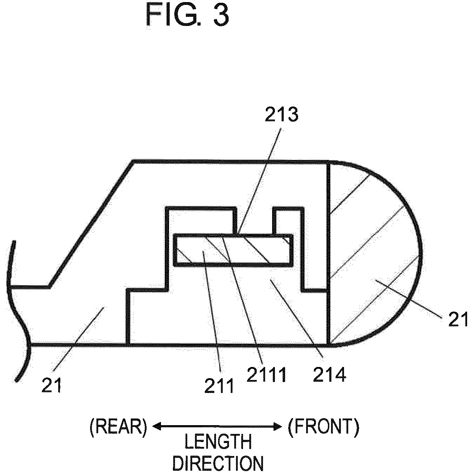

The start-up unit 21 includes first rotation supporting point 213. FIG. 3 is a cross-sectional schematic view in a length direction of a main part of start-up unit 21 illustrated in FIG. 2A. First rotation supporting point 213 is sufficient to be formed on start-up unit 21 to make attraction body 211 rotatable. Then, attraction body 211 turns around first rotation supporting point 213 as a center. Accordingly, it is preferable that holder 214 be provided on start-up unit 21. Holder 214 holds attraction body 211. Then, first rotation supporting point 213 is formed on holder 214. This structure makes attraction body 211 turn around first rotation supporting point 213 as a supporting point in holder 214.

The above structure makes attraction body 211 turn around first rotation supporting point 213 as a supporting point to incline in a direction along an inclination of power generation unit 22 depending on movement of start-up unit 21. This makes it possible to suppress reduction of a contact area between attraction body 211 and power generation unit 22 when attraction body 211 moves. In a state where power generation unit 22 and attraction body 211 are attracted, variation of attraction force between power generation unit 22 and attraction body 211 can be reduced. This makes it possible to suppress variation of a position where power generation unit 22 is separated from attraction body 211, which stables an amplitude width of power generation unit 22, making it possible to stable power generation amount by power generation unit 22.

Furthermore, as illustrated in FIG. 2B, both ends of attraction body 211 are protruded from beam 222 and attraction body 221 of power generation unit 22 in the width direction.

The both ends of attraction body 211 are extended to holder 214. First rotation supporting point 213 is in contact with the both ends of attraction body 211 in a state where attraction body 211 and attraction body 221 are attracted. In this state, attraction body 221 is attracted at a center of attraction body 211.

First rotation supporting point 213 is formed on start-up unit 21 in any manner as long as attraction body 211 can turn around. Although first rotation supporting point 213 is disposed to be in contact with attraction surface 2111 of attraction body 211, the present disclosure is not limited to the configuration. First rotation supporting point 213 may be disposed to be in contact with a surface of attraction body 211 on a side opposite to attraction surface 2111. Furthermore, first rotation supporting point 213 may be formed on attraction body 211. However, first rotation supporting point 213 needs to be formed such that attraction body 211 can turn around along an inclination of attraction surface 2211. A void that allows attraction body 211 to rotate is provided closer to the fixed end of power generation unit 22 than to first rotation supporting point 213. Then, when attraction body 211 turns around first rotation supporting point 213 as a supporting point, attraction body 211 closer to the fixed end of power generation unit 22 than to first rotation supporting point 213 is entered in the gap.

### [Another example of first rotation supporting point 213]

Next, another structure of first rotation supporting point 213 will be described. In the above-mentioned structure of holder 214 illustrated in FIG. 2A, first rotation supporting point 213 is formed by a projection. In contrast, first rotation supporting point 213 formed on start-up unit 21 illustrated in FIG. 3 is formed by a step portion.

FIG. 3 is a schematic view illustrating a cross-section of holder 214 in a longitudinal direction. First rotation supporting point 213 is preferably in contact with attraction surface 2111 at a distal end. This configuration enables attraction body 211 to turn around the projection or the distal end of the step portion.

### [Structure of case 23]

Case 23 preferably further includes separation portion 232 as illustrated in FIG. 1A. Distal end 2321 of separation portion 232 hits power generation unit 22 when power generation unit 22 is deflected by movement of start-up unit 21 to make start-up unit 21 be separated from power generation unit 22. This configuration enables to further suppress variation of a point where power generation unit 22 is separated from start-up unit 21.

### [Power generation operation by power generation device 11]

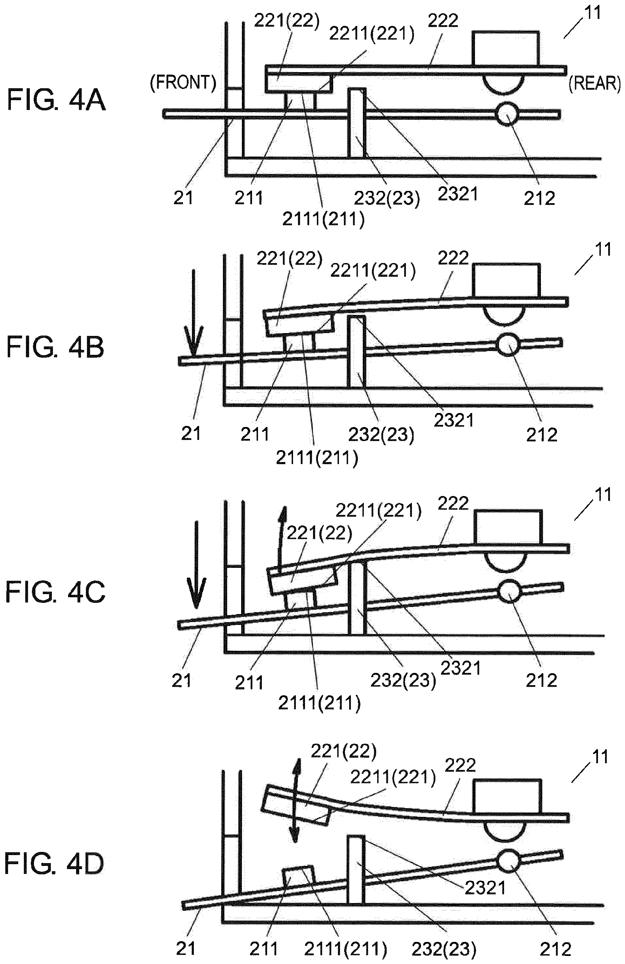

Next, operation of power generation by power generation device 11 will be described with reference to FIG. 4A to FIG. 6C. FIG. 4A to FIG. 4D, FIG. 5A to FIG. 5C, and FIG. 6A to FIG. 6C are operation explanatory diagrams of power generation device 11. It should be noted that the same reference numerals are used to refer to the same or similar components, and description thereof will be sometimes omitted.

First, with reference to FIG. 4A to FIG. 4D, operation of start-up unit 21 according to second rotation supporting point 212 will be described. FIG. 4A illustrates a state where start-up unit 21 is positioned at the start point. In this state, attraction body 221 is attracted to attraction body 211. That is, attraction surface 2111 and attraction surface 2211 are in contact.

FIG. 4B illustrates a state where start-up unit 21 moves from the start point toward the end point, and illustrates a state before start-up unit 21 is separated from power generation unit 22. Hereinafter, a point where start-up unit 21 is separated from power generation unit 22 will be denoted as "a separation point". That is, FIG. 4B illustrates a state before the separation point. Start-up unit 21 moves from the start point toward the end point so as to turn around second rotation supporting point 212 as a center. In this context, attraction body 211 and attraction body 221 move while the power generation unit is attracted to the attraction body. Accordingly, attraction body 221 moves toward an end-point direction with attraction body 211. Since power generation unit 22 has a cantilever shape, deflection occurs on a free end side (left side in FIG. 4A) of power generation unit 22, causing inclination of attraction surface 2211. In contrast, attraction body 211 can turn around second rotation supporting point 212 as a center of start-up unit 21. Accordingly, attraction surface 2111 turns around a direction along an inclination of attraction surface 2211. That is, attraction surface 2111 also enters an inclination state.

FIG. 4C illustrates a separation point of start-up unit 21 and power generation unit 22. On the way toward the end point from the start point of start-up unit 21, power generation unit 22 hits on distal end 2321 of separation portion 232. That is, separation portion 232 prevents power generation unit 22 from being further moved in the end-point direction. In contrast, start-up unit 21 can go beyond the separation point to move to the end point. Movement of start-up unit 21 beyond the separation point releases attraction state between attraction body 211 and attraction body 221. Then, by being separated from the start-up unit 21, power generation unit 22 starts to vibrate. Vibration of power generation unit 22 makes power generation unit 22 start power generation.

FIG. 4D illustrates a state where start-up unit 21 is positioned at the end point. In this state, power generation unit 22 continues free vibration, and then amplitude of the vibration gradually decays. Also during the time, attraction force is generated between attraction body 211 and attraction body 221 due to magnetic force. Then, when operation to start-up unit 21 (pressing force to start-up unit 21 toward the end point) is released, attraction body 211 (start-up unit 21) and attraction body 221 (power generation unit 22) are attracted with each other due to attraction force between attraction body 211 and attraction body 221. This configuration reconstitutes start-up unit 21 from the end point to the start point to return to the initial state illustrated in FIG. 4A. Even when attracted state between attraction body 211 and attraction body 221 are released by separation portion 232, attraction body 211 is attracted by attraction body 221, preventing attraction body 211 from falling.

### [Detailed description of first rotation supporting point]

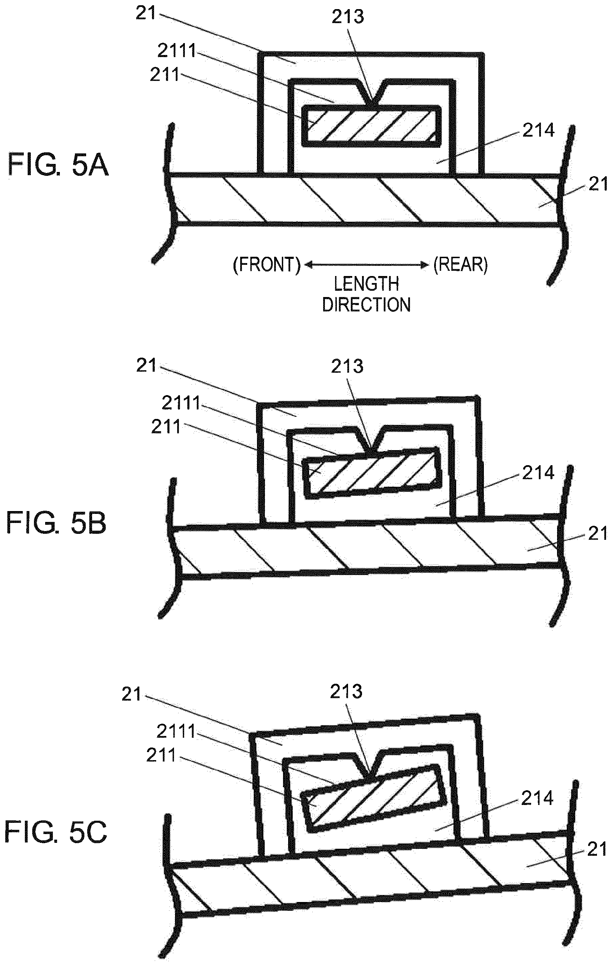

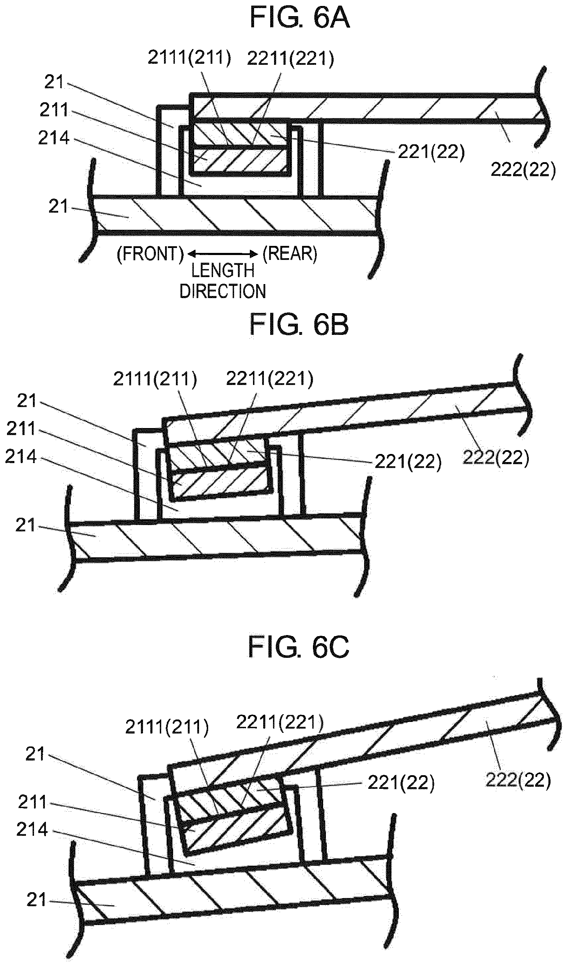

Next, operation by first rotation supporting point 213 will be described with reference to FIG. 5A to FIG 5C and FIG. 6A to FIG. 6C. FIG. 5A to FIG. 5C are diagrams for illustrating operation of attraction body 211 that turns around first rotation supporting point 213 as a supporting point depending on state of start-up unit 21. FIG. 6A to FIG. 6C are diagrams for illustrating inclinations and attraction state of attraction body 211 and attraction body 221 depending on state of start-up unit 21. FIG. 5A and FIG. 6A illustrate a state where start-up unit 21 is positioned at the start point. In the state illustrated in FIG. 5A and FIG. 6A, attraction body 221 is attracted to attraction body 211 as illustrated in FIG. 4A. That is, attraction surface 2111 and attraction surface 2211 are in contact.

FIGS. 5A to 5C are cross-sectional views in the length direction of an end of start-up unit 21 in the width direction. As illustrated in FIG. 2B, a width of attraction body 211 is wider than that of attraction body 221. Accordingly, in the cross-sectional views illustrated in FIG. 5A to FIG. 5C, attraction body 211 is illustrated but attraction body 221 is not illustrated like FIG. 3.

FIG. 5B and FIG. 6B illustrate a state at a timing same as that in FIG. 4B. FIG. 5C and FIG. 6C illustrate a state at a timing same as that in FIG. 4C. In the state of FIG. 4B and the state in FIG. 4C, attraction surface 2211 is in inclination states. In contrast, attraction body 211 can turn around first rotation supporting point 213 as a supporting point. Accordingly, attraction surface 2111 turns around first rotation supporting point 213. That is, attraction surface 2111 is in a state inclined in a direction along an inclination of attraction surface 2211. Accordingly, while start-up unit 21 is moved from the start point to the separation point, attracted state between attraction surface 2111 and attraction surface 2211 are kept. Accordingly, power generation device 11 suppresses variation or the like of attraction force between attraction body 211 and attraction body 221. Power generation device 11 can also reduce variation of position (separation point) where start-up unit 21 and power generation unit 22 are separated. This makes it possible to reduce variation of amplitude of power generation unit 22, so that power generation unit 22 can reduce variation of power generation amount.

### (First modification of exemplary embodiment)

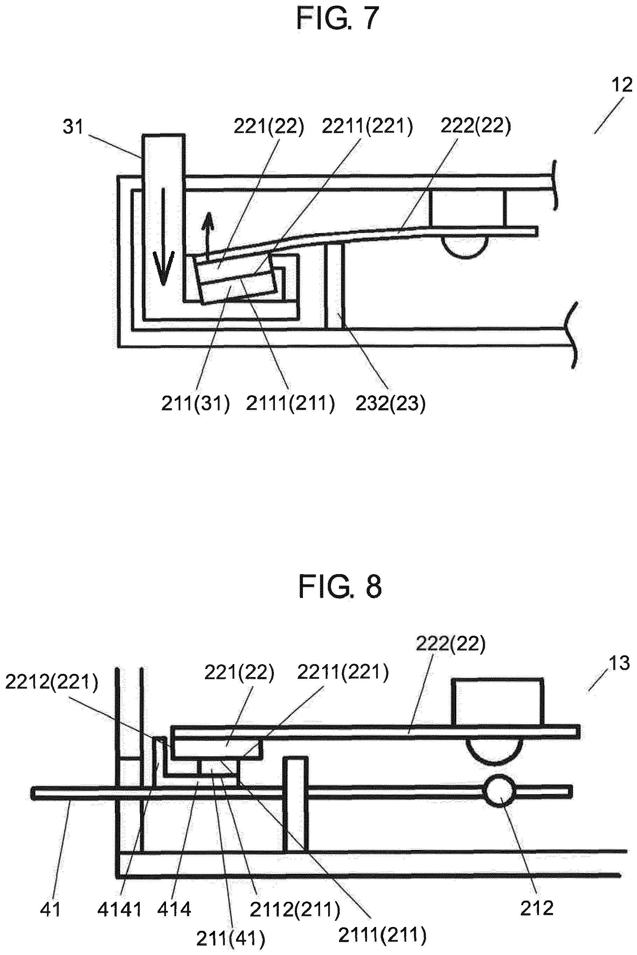

FIG. 7 is a schematic view of power generation device 12 using start-up unit 31 as another embodiment of the present invention. Power generation device 12 uses start-up unit 31 instead of start-up unit 21 illustrated in FIG. 1A. Start-up unit 21 illustrated in FIG. 1A is configured to turn around, but start-up unit 31 moves in a straight manner. This point differs from start-up unit 21. In this case, start-up unit 31 has first rotation supporting point 213 (see FIG. 5A, etc.). Then, start-up unit 31 and start-up unit 21 illustrated in FIG. 1A are similar in their configurations in which attraction body 211 is made to turn around first rotation supporting point 213 as a center.

By the above configuration, also in start-up unit 31 that moves in a straight manner, attraction body 211 inclines in a direction along an inclination of attraction body 221 depending on movement of attraction body 31. This makes it possible to suppress reduction of a contact area between attraction body 211 and attraction body 221 when the start-up unit 31 is moved. This makes it possible to reduce variation of attraction force between attraction body 221 and attraction body 211 in a state where attraction body 221 and attraction body 211 are attracted. This makes it possible to suppress variation of a position where attraction body 221 is separated from attraction body 211, which stables amplitude width of power generation unit 22, making it possible to stable power generation amount by power generation unit 22.

### (Second modification of exemplary embodiment)

FIG. 8 is a schematic view of a power generation device using start-up unit 41 as a still another example, outside the scope of the present invention. Note that FIG. 8 illustrates a state where start-up unit 41 is positioned at the start point. Power generation device 13 can use start-up unit 41 instead of start-up unit 21 illustrated in FIG. 1A. Note that start-up unit 41 includes attraction body 211. Then, that attraction surface 2111 of attraction body 211 is attracted to attraction surface 2211 is similar to other exemplary embodiments. Attraction body 211 of start-up unit 41 turns around only by second rotation supporting point 212. Start-up unit 41 also includes yoke 414. Yoke 414 is coupled with a surface (surface 2112) on a side opposite to attraction surface 2111 of attraction body 211. This configuration improves attraction force between attraction body 221 and attraction body 211.

Yoke 414 further includes bent portion 4141 bent in an L character shape and extended. Then, a part of bent portion 4141 is disposed to oppose a surface (side surface 2212) of attraction body 221 on a distal end side of power generation unit 22. This configuration improves attraction force between attraction body 221 and attraction body 211.

Note that the present disclosure is not limited to above-mentioned exemplary embodiments, and various modifications are possible, and it goes without saying that they are also included in the scope of the present invention which is solely defined by the appended claims.

Also, terms indicating directions such as "width direction", "length direction", and the like are used for easy understanding of the exemplary embodiment, and only illustrate relative positional relationships.

### INDUSTRIAL APPLICABILITY

As described above, the power generation device according to the present invention has an advantageous effect that it can stable power generation amount of the power generation unit, and is useful for use in an independent electronic apparatus or the like.

### REFERENCE MARKS IN THE DRAWINGS

- 11, 12, 13: power generation device
- 21, 31, 41: start-up unit
- 22: power generation unit
- 23: case
- 211, 221: attraction body
- 212: second rotation supporting point
- 213: first rotation supporting point
- 214: holder
- 222: beam
- 231: spacer
- 232: separation portion
- 414: yoke
- 2111, 2211: attraction surface
- 2112: surface
- 2212: side surface
- 2221: root
- 2321: distal end
- 4141: bent portion

## Claims

1. A power generation device (11, 12) comprising:
a start-up unit (21, 31) that includes an attraction body (211) and moves from a start point toward an end point; and
a power generation unit (22) that generates electricity by being vibrated, the power generation unit having a cantilever shape,
wherein
the attraction body (211) attracts the power generation unit (22) when the start-up unit (21) moves from the start point toward the end point,
the power generation unit (22) deflects and inclines due to movement of the attraction body (211) of the start-up unit (21, 31) and the power generation unit (22) toward the end point while the power generation unit (22) is attracted to the attraction body (211),
the power generation unit (22) starts to vibrate by separation of the attraction body (211) from the power generation unit (22), and
the attraction body (211) inclines in a direction along an inclination of the power generation unit (22),
**characterised in that** a first rotation supporting point (213) is provided on the start-up unit (21, 31) such that the attraction body (211) turns around the first rotation supporting point (213) as a center, and
the first rotation supporting point (213) is a projection provided on the start-up unit (21, 31) or a distal end of a step portion provided on the start-up unit (21, 31).

2. The power generation device according to claim 1, wherein
the start-up unit (21) includes a second rotation supporting point (212) disposed closer to a fixed end of the power generation unit (22) than the attraction body (211), and
the attraction body (211) of the start-up unit (21) inclines in the direction along the inclination of the power generation unit (22) due to turning of the start-up unit (21) around the second rotation supporting point (212) as a center when the start-up unit (21) moves from the start point toward the end point.

3. The power generation device according to claim 1, wherein
the attraction body (211) has an attraction surface (2111) opposing the power generation unit (22), and
the first rotation supporting point (213) is in contact with the attraction surface (2111).

## Patentansprüche

1. Stromerzeugungsvorrichtung (11, 12) umfassend:
eine Starteinheit (21, 31), die einen Anziehungskörper (211) einschließt und sich von einem Startpunkt zu einem Endpunkt bewegt; und
eine Stromerzeugungseinheit (22), die Elektrizität erzeugt, indem sie in Schwingungen versetzt wird, wobei die Stromerzeugungseinheit eine freitragende Form aufweist,
wobei
der Anziehungskörper (211) die Stromerzeugungseinheit (22) anzieht, wenn sich die Starteinheit (21) vom Startpunkt zum Endpunkt bewegt,
die Stromerzeugungseinheit (22) sich aufgrund der Bewegung des Anziehungskörpers (211) der Starteinheit (21, 31) und der Stromerzeugungseinheit (22) in Richtung des Endpunkts durchbiegt und neigt, während die Stromerzeugungseinheit (22) von dem Anziehungskörper (211) angezogen wird,
die Stromerzeugungseinheit (22) durch Trennung des Anziehungskörpers (211) von der Stromerzeugungseinheit (22) zu schwingen beginnt, und
der Anziehungskörper (211) sich in einer Richtung entlang einer Neigung der Stromerzeugungseinheit (22) neigt,
**dadurch gekennzeichnet, dass**
ein erster Rotationsauflagepunkt (213) an der Starteinheit (21, 31) vorgesehen ist, so dass sich der Anziehungskörper (211) um den ersten Rotationsauflagepunkt (213) als Zentrum dreht, und
der erste Rotationsauflagepunkt (213) ein an der Starteinheit (21, 31) vorgesehener Vorsprung oder ein distales Ende eines an der Starteinheit (21, 31) vorgesehenen Stufenabschnitts ist.

2. Stromerzeugungsvorrichtung nach Anspruch 1, wobei
die Starteinheit (21) einen zweiten Rotationsauflagepunkt (212) einschließt, der näher an einem festen Ende der Stromerzeugungseinheit (22) angeordnet ist als der Anziehungskörper (211), und
der Anziehungskörper (211) der Starteinheit (21) sich in der Richtung entlang der Neigung der Stromerzeugungseinheit (22) aufgrund der Drehung der Starteinheit (21) um den zweiten Rotationsauflagepunkt (212) als Zentrum neigt, wenn sich die Starteinheit (21) von dem Startpunkt zu dem Endpunkt bewegt.

3. Stromerzeugungsvorrichtung nach Anspruch 1, wobei
der Anziehungskörper (211) eine Anziehungsfläche (2111) aufweist, die der Stromerzeugungseinheit (22) gegenüberliegt, und der erste Rotationsauflagepunkt (213) mit der Anziehungsfläche (2111) in Kontakt steht.

## Revendications

1. Dispositif de génération de puissance (11, 12) comprenant :
une unité de démarrage (21, 31) qui comporte un corps d'attraction (211), et qui se déplace d'un point de départ vers un point d'arrivée ; et
une unité de génération de puissance (22) qui génère de l'électricité en vibrant, l'unité de génération de puissance ayant une forme en porte-à-faux, dans lequel
le corps d'attraction (211) attire l'unité de génération de puissance (22) lorsque l'unité de démarrage (21) se déplace du point de départ vers le point d'arrivée,
l'unité de génération de puissance (22) dévie et s'incline en raison du déplacement du corps d'attraction (211) de l'unité de démarrage (21, 31) et de l'unité de génération de puissance (22) vers le point d'arrivée tandis que l'unité de génération de puissance (22) est attirée par le corps d'attraction (211),
l'unité de génération de puissance (22) commence à vibrer par la séparation du corps d'attraction (211) de l'unité de génération de puissance (22), et
le corps d'attraction (211) s'incline dans une direction le long d'une inclinaison de l'unité de génération de puissance (22),
**caractérisé en ce que**
un premier point de support de rotation (213) est prévu sur l'unité de démarrage (21, 31), de sorte que le corps d'attraction (211) tourne autour du premier point de support de rotation (213) comme centre, et
le premier point de support de rotation (213) est une saillie prévue sur l'unité de démarrage (21, 31) ou une extrémité distale d'une partie étagée prévue sur l'unité de démarrage (21, 31).

2. Dispositif de génération de puissance selon la revendication 1, dans lequel
l'unité de démarrage (21) comporte un deuxième point de support de rotation (212) disposé plus près d'une extrémité fixe de l'unité de génération de puissance (22) que le corps d'attraction (211), et
le corps d'attraction (211) de l'unité de démarrage (21) s'incline dans la direction le long de l'inclinaison de l'unité de génération de puissance (22) en raison de la rotation de l'unité de démarrage (21) autour du deuxième point de support de rotation (212) comme centre lorsque l'unité de démarrage (21) se déplace du point de départ vers le point d'arrivée.

3. Dispositif de génération de puissance selon la revendication 1, dans lequel
le corps d'attraction (211) a une surface d'attraction (2111) opposée à l'unité de génération de puissance (22), et
le premier point de support de rotation (213) est en contact avec la surface d'attraction (2111).
